# EUROPEAN PATENT SPECIFICATION

(11) **EP 1 509 379 B1**
(45) Date of publication and mention of the grant of the patent: **29.02.2012**
(21) Application number: 03734468.6
(22) Date of filing: 27.05.2003
(51) Int. Cl.: B29C 43/36

(54) **METHODS AND APPARATUS OF FIELD-INDUCED PRESSURE IMPRINT LITHOGRAPHY**
VERFAHREN UND VORRICHTUNG ZUR PRÄGEFORMLITHOGRAPHIE MIT FELDINDUZIERTEM DRUCK
PROCEDES ET APPAREIL D'EMPREINTE LITHOGRAPHIQUE PAR PRESSION INDUITE PAR DES CHAMPS

(30) Priority: 24.05.2002 US 382961 P; 16.09.2002 US 244276
(43) Date of publication of application: 02.03.2005
(73) Proprietor: Chou, Stephen Y., Princeton, NJ 08540 (US); Zhang, Wei, Plainsboro, NJ 08536 (US)
(72) Inventor: Chou, Stephen Y., Princeton, NJ 08540 (US); Zhang, Wei, Plainsboro, NJ 08536 (US)
(74) Representative: Beresford, Keith Denis Lewis
(86) International application number: PCT/US2003/018020
(87) International publication number: WO 2003/099536

(56) References cited:
- WO-A-00/21689
- WO-A-03/024186
- US-A- 5 352 394
- US-A- 5 352 394
- US-A- 6 056 526
- US-A- 6 056 526
- US-A1- 2003 215 577

## Description

### FIELD OF THE INVENTION

This invention relates to imprint lithography and, in particular, to imprint lithography wherein electrical or magnetic fields are used to imprint a molding surface onto a moldable surface. The process is particularly useful to provide nanoimprint lithography of enhanced resolution and uniformity over an increased area.

### BACKGROUND OF THE INVENTION

Photolithography is a key process in the fabrication of semiconductor integrated circuits and many optical, magnetic and micromechanical devices. Lithography creates a pattern on a thin film carried on a substrate so that, in subsequent process steps, the pattern can be replicated in the substrate or in another material which is added onto the substrate. Conventional lithography typically involves applying a thin film of resist to a substrate, exposing the resist to a desired pattern of radiation, and developing the exposed film to produce a physical pattern. In this approach, resolution is limited by the wavelength of the radiation, and the equipment becomes increasingly expensive as the feature size becomes smaller.

Imprint lithography, based on a fundamentally different principle, offers high resolution, high throughput, low cost and the potential of large area coverage. In imprint lithography, a mold with microscale or nanoscale features is pressed into a thin film, deforming the shape of the film according to the features of the mold and forming a relief pattern in the film. After the mold is removed, the thin film can be processed to remove the reduced thickness portions. This removal exposes the underlying substrate for further processing. Details of imprint lithography are described in applicant's United States Patent No. 5,772,905 issued June 30, 1998 and entitled "Nanoimprint Lithography", the '905 patent.

The usual method of pressing the mold into the thin film involves positioning the mold and the substrate on respective rigid plates of a high precision mechanical press. With such apparatus, the process can generate sub-25 nm features with a high degree of uniformity over areas on the order of 12 in². Larger areas of uniformity would be highly advantageous to increase throughput and for many applications such as displays.

The use of a high precision mechanical press to press a mold into a thin film presents tolerance problems in replicating small patterns over large areas. Presses move on guide shafts through apertures, and the spacings between the shafts and their respective apertures can be large compared to the features to be replicated. Such spacings permit undesirable relative translational and rotational shifts between the substrate and the mold. Moreover, despite the most careful construction, the molds and the substrates used in lithography are not perfectly planar. When these molds and substrates are disposed on the rigid plates of a press, the deviations from planarity over large areas can result in variations in the molding pressure and depth of imprint. Accordingly, it is desirable to provide a method of imprint lithography which avoids the limitations of mechanical presses.

An alternative method of pressing the mold into the thin film is the technique of fluid pressure imprint lithography described in applicant's United States Patent No. 6,482,742 issued November 19, 2002 and entitled "Fluid Pressure Imprint Lithography". In this method the molding surface is disposed adjacent the film, the molding surface/film interface is sealed and pressurized fluid is used to force the molding surface into the film. Since the pressure is isostatic, translational and rotational shifts are minimal, and smaller features can be imprinted with high uniformity over larger areas than can be imprinted using mechanical presses.

Fluid pressure imprinting has dramatically improved nanoimprint lithography. A further improvement for commercial manufacture would be a method which could provide comparable results without the necessity of sealing the molding surface/film interface.

US 5,352,394 describes an injection molding apparatus on which an injection device injects material in a molton state into a cavity, formed between two molds held together by forces applied using electromagnetic coils.

US 6,056,526 describes a tool for molding an exposed surface of a resin sealant material using an elongated member comprising a magnetic material whereby pressing force is applied using a magnetic pressing member.

WO00/21689 describes a nano-lithographic method in which a patterned mask is separated from a thin film by a gap. Electrostatic forces between the corners of the mark pattern and the film cause the formation of pillars.

WO 03024186, published after the priority date of the present application and therefore cited under Article 54(3) and (4) EPC describes use of an electric charge passed from a stamp through a conductive fluid medium to impart a pattern to a substrate.

### SUMMARY OF THE INVENTION

Aspects of the present invention are set out in the appended independent claims.

An improved method of imprint lithography involves using field-induced pressure from electric or magnetic fields to press a mold into a substrate having a moldable surface. In essence, the method comprises the steps of providing a substrate having a moldable surface, providing a mold having a molding surface and pressing the molding surface and the moldable surface together by electric or magnetic fields to imprint the molding surface onto the moldable surface. The molding surface advantageously comprises a plurality of projecting features of nanoscale extent or separation, but the molding surface can also be a smooth planar surface, as for planarization. The improved method can be practiced without mechanical presses and without sealing the region between the mold and the substrate.

### BRIEF DESCRIPTION OF THE DRAWINGS

The advantages, nature and various additional features of the invention will appear more fully upon consideration of the illustrative embodiments now to be described in detail in connection with the accompanying drawings. In the drawings:
Fig. 1 is a schematic flow diagram of the steps in an improved method of imprint lithography;
Fig. 2 illustrates apparatus for practicing the method of Fig. 1 using an electrical field;
Figs. 3A, 3B and 3C show various substrate constructions for facilitating electrical contact with a substrate conductive layer;
Fig. 4 shows an alternative apparatus for practicing the method of Fig. 1 without direct electrical contact;
Fig. 5 illustrates apparatus for practicing the method of Fig. 1 using a magnetic field;
Fig. 6A and 6B show exemplary multilayer mold constructions useful for the apparatus of Figs. 2, 4 and 5; and
Fig. 7 schematically illustrates how the method of Fig. 1 is compatible with a variety of other processing steps.

It is to be understood that these drawing are for purposes of illustrating the concepts of the invention and are not to scale.

### DETAILED DESCRIPTION

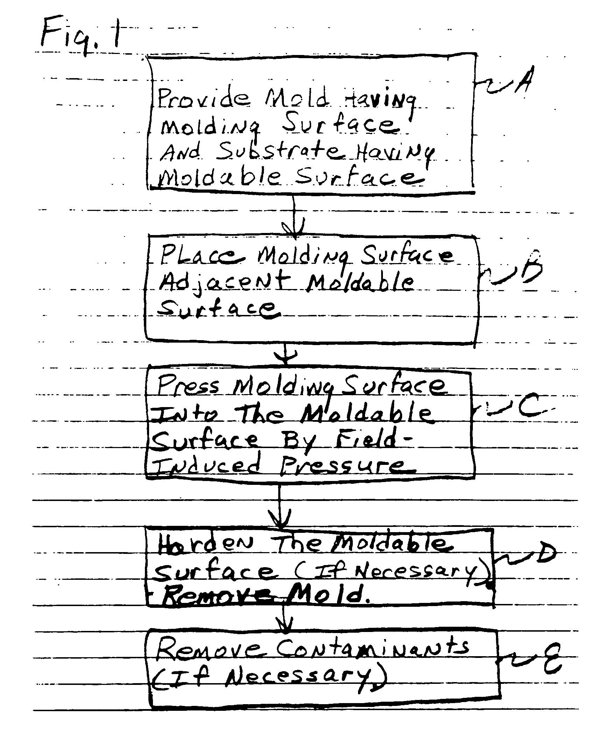

Referring to the drawings, Fig. 1 is a schematic flow diagram of an improved process for imprint lithography using field-induced pressure. An initial step shown in Block A, is to provide a mold having a molding surface such as plurality of protruding features and a substrate having a surface of moldable material such as one or more moldable thin films. Protruding features are preferably micrometer scale features and, more advantageously, nanoscale features. The method is highly advantageously where the mold surface has at least two spaced apart protruding features. A moldable material is one which retains or can be hardened to retain the imprint of the protruding features from the mold surface.

The next step, shown in Block B, is to place the mold adjacent the moldable surface. If the moldable surface is a thin film that already includes a previously formed pattern, then the pattern of the mold should be carefully aligned with the previous pattern. This can be done by alignment techniques well known in the art.

The third step (Block C) is to press the mold onto the moldable surface by field-induced pressure. One method for doing this is to dispose the assembly between conductive layers and apply an electrical field between the layers. Another approach is to dispose the assembly between layers of magnetic material and to apply a magnetic field that will force the layers together. The advantage of field-induced pressure is that the resulting force uniformly pushes the mold onto the moldable surface. Shear or rotational components are *de minimus.* Moreover since the mold and/or substrate are flexible rather than rigid, conformation between the mold and the moldable surface is achieved regardless of unavoidable deviations from planarity. The result is an enhanced level of molding resolution, alignment and uniformity over an increased area of the film.

The next step shown in Block D, is to harden the moldable surface, if necessary, so that it retains the imprint of the mold and then to remove the mold. The process for hardening depends on the material of the moldable surface. Some materials will maintain the imprint with no hardening. Thermoplastic materials can be hardened by preliminarily heating them prior to molding and permitting them to cool after imprint. PMMA, for example, can be suitably softened by heating to 120° C prior to molding and hardened by cooling after imprint. Heat curable materials can be hardened by applying heat during imprint. A heater and/or the use of a heated pressurized fluid can thus effectuate such softening or hardening. Radiation curable materials can be hardened by the application of UV radiation during imprint. Silicon can be softened by UV laser radiation to accept imprinting and hardened by cooling to ambient temperature.

The fifth step shown in Block E is optional in some applications. It is to remove contaminants (if any) and excess material from the recesses of the molded surface. The molded surface will typically have raised features and recesses. In many lithographic operations it is desirable to eliminate the material from the recesses so that the underlying substrate is exposed for further processing. This can be conveniently accomplished using reactive ion etching.

In some applications, the imprinted structure itself is a part of a device to be built. In other applications the resulting structure is a resist-covered semiconductor substrate with a pattern of recesses extending toward the substrate. Such a structure can be further processed in a variety of ways well-known in the art. For example, the molded film can be used as a mask for the removal of surface layers in exposed regions of the substrate, for doping exposed regions of the substrate or for growing or depositing materials on the exposed regions.

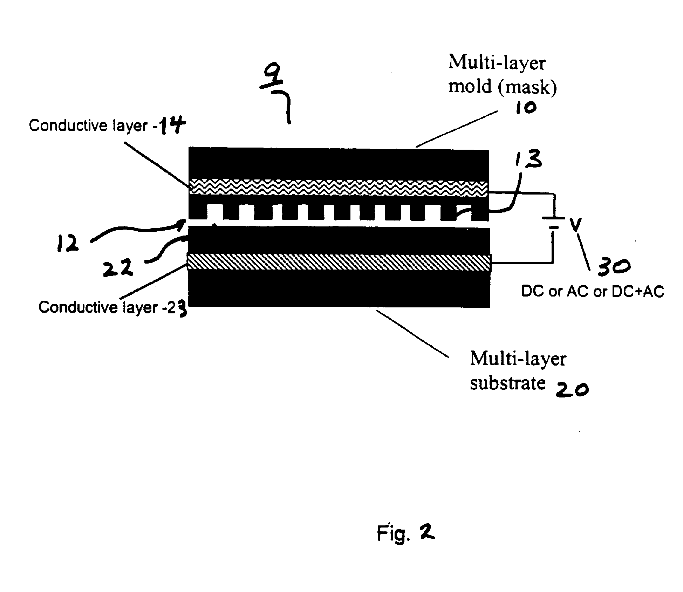

Fig. 2 schematically illustrates a first exemplary apparatus 9 for practicing the method of Fig. 1. The apparatus 9 comprises an assembly of a mold 10 having a molding surface 12 and a substrate 20 having a moldable surface 22. The mold and substrate are disposed with the molding surface 12 adjacent the moldable surface 22. The mold 10 comprises a body having a molding surface 12. Surface 12 can include a plurality of protruding features 13 having a desired shape for imprinting onto the moldable surface 22. The molding surface 12 can be patterned into protruding features 13 of nanoscale dimensions by known techniques such as electron beam lithography. The projecting extent of the protruding features 13 is typically in the range 0.1 nm to 200 µm. Typical separations between protruding features are 200 nanometers or less. Advantageously the mold 10 is a multilayer structure comprising a layer of conductive or chargeable material that is distal to the interface between the molding surface and the moldable surface. The term layer as used herein is intended broadly to cover a supported layer, a plate or a composite layer.

The substrate 20 is typically a solid substrate and the moldable surface 22 is typically a thin film of polymer, monomer, oligomer or combination thereof that is pliable or can be made pliable to pressure and can retain a pressure-imprinted deformation or pattern. It can be a thermoplastic polymer, such as polycarbonate or polymethyl methacrylate (PMMA), which softens in response to heat. Alternately it can be a monomer liquid, such as a curable silicone, which hardens with curing. Yet further in the alternative, it can be solid silicon which can be liquefied by a UV laser pulse. Polymer thin films are typically applied to the substrate by spraying or spinning. Advantageously the film does not adhere to the mold surface. If necessary, the mold surface can be coated with a release agent to prevent such adherence. Advantageously the substrate is a multilayer structure comprising a layer or plate 23 of conductive or chargeable material that is distal to the molding surface/moldable surface interface.

The pressure between the mold and the substrate can be generated by electrical or magnetic forces between the mold and the substrate. For a pressure generated by an electrical force, an attractive electrical field can be established between the mold and the substrate. Alternatively a repulsive field can be used to drive the mold and the substrate together. For a pressure generated by a magnetic force, an attractive magnetic force between the mold and the substrate can provide attractive pressure or repulsive external magnetic forces can drive the mold and the substrate together.

In use, a field forces the molding surface onto the moldable surface. In the embodiment of Fig. 2 where the field is an electric field, this imprinting can be effected by connecting layers 14 and 23 to opposite polarity terminals of a voltage source 30. The voltage from source 30 can be AC, DC, pulsed, or a combination of such voltages.

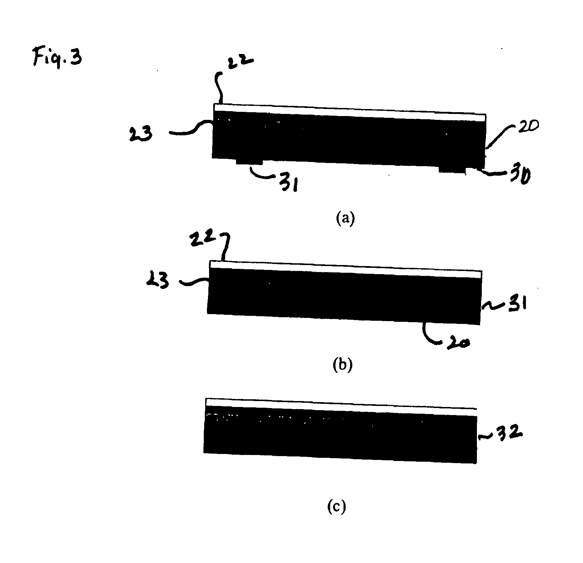

Electrical connection with layers 14 and 23 can be facilitated by choosing substrate 20 to be conductive and mold 10 to be conductive. Alternatively, conductive through holes (not shown) through substrate 20 to layer 23 and through mold 10 to layer 14 can provide connection. Figs. 3A, 3B and 3C show substrate constructions that facilitate electrical connection with substrate conductive layer 23. In Fig. 3A, electrical contact can be made from the bottom of substrate 20 through conductive vias 30. In Fig. 3B electrical contact can be made from the bottom or from the lateral edges by coating or plating a peripheral layer 31 of conductive material around a portion of the lateral periphery of the substrate 20. A similar peripheral conductive layer 32 is shown in Fig. 3C except that layer 32 does not extend to the bottom of the substrate. Yet further in the alternative, an electric field for imprinting the substrate can be created between appropriately dissimilar materials by the use of light, heat or RF radiation.

In some applications it may be advantageous to make the mold 10 or the substrate 20 (including the conductive layers) of materials at least partially transparent to radiation which can be used to soften or cure the moldable surface.

In other applications it may be desired to omit one of the conductive layers 14, 23 and to use an attractive or repulsive field between an external electrode and the remaining layer to force the molding surface and the moldable surface together.

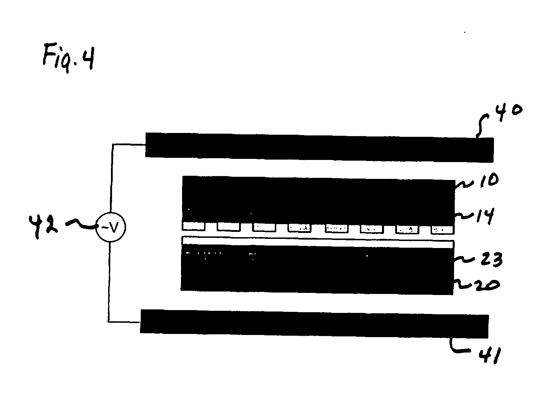

Fig. 4 shows an alternative apparatus for using an electrical field to press the molding surface into the moldable surface. The apparatus of Fig. 4 is similar to that of Fig. 2 except that rather than directly connecting the layers 14 and 23 to a voltage source, the mold 10/substrate 20 assembly is disposed between electrodes 40 and 41 that are connected to an AC voltage source 42. The frequency of the AC source can be tuned to generate a desired induced voltage between layers 14 and 23.

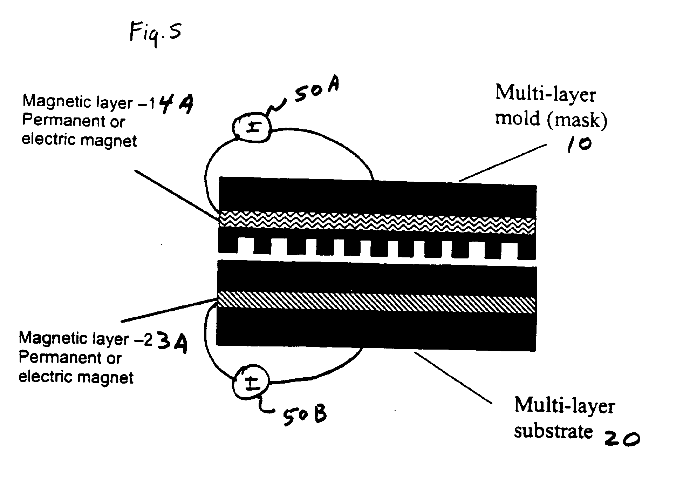

Fig. 5 illustrates alternative apparatus for practicing the method of Fig. 1. The Fig. 5 apparatus is similar to the apparatus of Fig. 2 except that instead of conductive layers, magnetic layers 14A, 23A are disposed distal to the mold/substrate interface and a magnetic field is used to imprint the mold surface into the moldable surface. The magnetic layers can be magnetizable material, permanent magnets or electromagnets. For example, layers 14A, 23A can comprise helically or spirally wound coils. Current from current sources 50A, 50B applied to coils can produce an attractive magnetic field to press the molding surface onto the moldable surface. Connections between the current sources and their respective coils can be facilitated by conduction through conductive vias (not shown) in the substrate and the mold. In a modified form, layers 14A and 23A can be magnetic materials that attract one another, and the current sources can be omitted. In another variation, the mold can comprise an electromagnet and the substrate can comprise a layer of magnetizable or permanent magnetic material or vice versa. In essence, what is needed is a magnetic layer and a magnetic field generator interacting with the magnetic layer to press the molding surface and the moldable surface together.

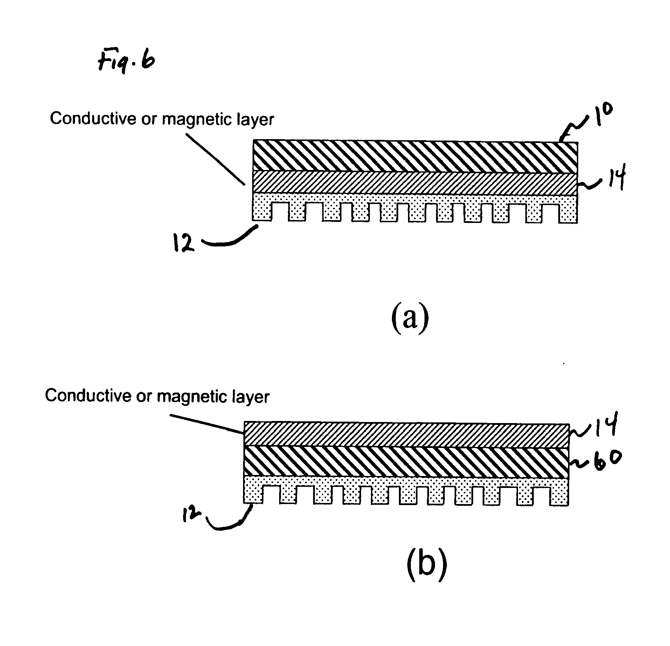

Figs. 6A and 6B show different multilayer mold constructions useful in the embodiments of Figs. 2-5. In Fig. 6A, the conductive or magnetic layer 14 is disposed immediately distal to the interface between the molding surface 12 and the moldable surface (not shown). In Fig. 6B, the conductive or magnetic layer 14 is still distal to the interface on the mold side, but there is an intervening layer 60.

It is further contemplated that field-induced imprinting can be used in conjunction with other methods of providing imprint pressure such as direct fluid pressure or mechanical pressure in all possible permutations in applying these forces, including applying them simultaneously, sequentially, or selectively.

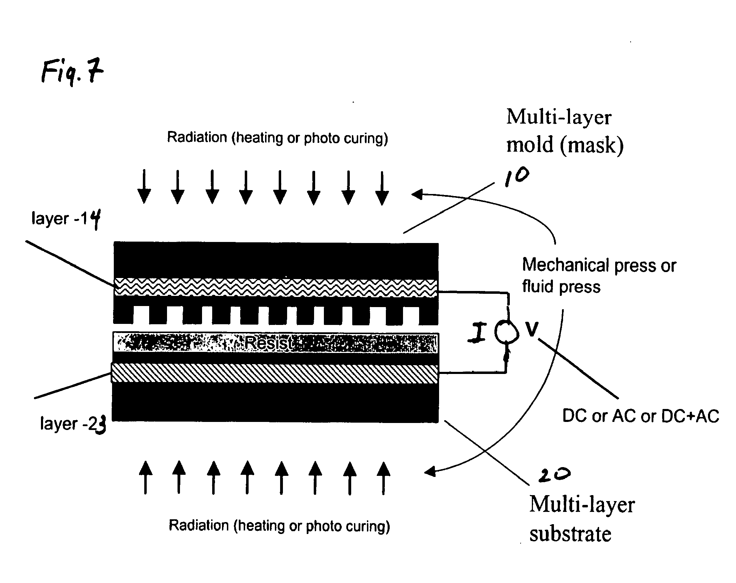

Fig. 7 schematically illustrates additional steps compatible with the process described herein. Precision mechanical pressing or pressurized fluid pressing can be of supplemental use, particularly after the molding surface is engaged with the moldable layer. Radiation, such as infrared or ultraviolet, can be used for heating, softening, or curing the moldable surface material. The layers 14, 23 can be conductive or magnetic, and the pressing fields can be DC, AC, or combinations thereof.

It is to be understood that the above described embodiments are illustrative of only a few of the many embodiments which can represent applications of the invention. Numerous and varied other arrangements can be made by those skilled in the art without departing from the scope of the invention which is defined by the attached claims.

## Claims

1. A method of nano-imprint lithography for processing a moldable surface (22) comprising the steps of:
providing (A) a substrate (20) having the moldable surface;
providing (A) a mold (10) having a molding surface (12) patterned with protruding features of nanoscale dimensions;
pressing (C) the molding surface and the moldable surface together by electric or magnetic field induced pressure to imprint the molding surface onto the moldable surface at an interface between the moldable and molding surfaces; and
withdrawing (D) the mold from the moldable surface; **characterised in that**, in the case of electric field induced pressure, the mold and substrate comprise multilayer structures (10,20) comprising respective layers (14,23) of chargeable or conductive material distal to the interface between the molding surface and the moldable surface; and
in the case of magnetic field induced pressure, the mold and the substrate comprise multilayer structures (10,20) comprising respective layers (14A,23A) of magnetic material distal to the interface between the molding surface and the moldable surface; and
wherein at least one of the multilayer structures is flexible.

2. The method of claim 1 wherein the moldable surface comprises one or more moldable layers disposed on the substrate.

3. The method of claim 2 wherein the imprinting produces reduced thickness regions in the moldable layer and further comprising the steps of:
removing the material of the moldable layer from the reduced thickness regions to selectively expose regions of the substrate; and
further processing the substrate selectively in the exposed regions.

4. The method of claim 3 wherein the further processing comprises doping the substrate with impurities, removing material from the substrate, or adding material on the substrate.

5. The method of claim 1 further comprising the step of hardening (D) the moldable surface after pressing.

6. The method of claim 1 wherein the substrate or the mold or both are sufficiently flexible to conform together under the pressure.

7. The method of claim 2 where the thickness of the moldable layer is in the range 0.1 nm to 200 µm.

8. Nano-imprint lithography apparatus for imprinting a moldable surface (22) on a substrate (20), the apparatus comprising:
a mold (10) having a molding surface (12) patterned with protruding features (13) of nanoscale dimensions;
a substrate (20) having a moldable surface (22) positioned adjacent the molding surface of the mold;
means (14,23) for forming an electrical field between the mold and substrate to press the molding surface and the moldable surface together at an interface between the moldable and molding surfaces;
**characterised in that** the mold and substrate comprise multilayer structures (10,20) comprising respective first and second layers (14,22) of chargeable or conductive material distal to the interface between the molding surface and the moldable surface; and
wherein at least one of the multilayer structures is flexible.

9. The apparatus of claim 8 wherein at least one of the first and second layers is conductive and the means for forming an electrical field comprises a voltage source (30).

10. The apparatus of claim 9 wherein the first and second layers comprise conductive material.

11. The apparatus of claim 9 wherein the voltage source comprises a DC voltage source.

12. The apparatus of claim 9 wherein the voltage source comprises an AC voltage source.

13. The apparatus of claim 9 wherein the voltage source comprises a pulsed voltage source.

14. The apparatus of claim 9 wherein the voltage source can provide a combination of DC, AC and pulsed voltage.

15. The apparatus of claim 9 wherein the mold includes a conductive layer (14).

16. The apparatus of claim 10 wherein the voltage source is connected between the layers of conductive material.

17. The apparatus of claim 9 wherein the mold and the substrate are disposed between at least two external electrodes (40,41) and the means for forming an electrical field comprises a voltage source to apply a voltage between the external electrodes.

18. The apparatus of claim 17 wherein the voltage source is an AC or pulsed voltage source.

19. Nano-imprint lithography apparatus for imprinting a moldable surface on a substrate (20) comprising:
a mold (10) having a molding surface (22) patterned with protruding features (13) of nanoscale dimensions;
a substrate (20) having a moldable surface positioned adjacent the molding surface;
and a magnetic field generator (50A, 50B) adapted to generate a magnetic field to press the molding surface and the moldable surface together at an interface between the moldable and molding surfaces;
**characterised in that** the mold and the substrate comprise multilayer structures (10,20) comprising respective layers (14A,23A) of magnetic material distal to the interface between the molding surface and the moldable surface; and
wherein at least one of the multilayer structures is flexible.

20. The apparatus of claim 19 wherein the magnetic layer comprises a conductive coil or spiral.

21. The apparatus of claim 19 wherein the magnetic field generator comprises a conductive coil or spiral.

22. The apparatus of claim 19 wherein the magnetic layer comprises a layer of magnetized material.

23. The apparatus of claim 19 wherein the magnetic layer comprises a layer of magnetizable material.

## Patentansprüche

1. Verfahren zur Nano-Prägelithographie zum Verarbeiten einer formbaren Oberfläche (22), das die folgenden Schritte umfaßt:
Bereitstellen (A) eines Substrats (20) mit der formbaren Oberfläche;
Bereitstellen (A) eines Formkörpers (10) mit einer Formungsoberfläche (12), die mit hervorstehenden Merkmalen von Nanoskalendimensionen gemustert ist;
Zusammendrücken (C) der Formungsoberfläche und der formbaren Oberfläche mittels von einem elektrischen oder magnetischen Feld induzierten Druck, um die Formungsoberfläche auf die formbare Oberfläche an einer Schnittstelle zwischen der formbaren Oberfläche und der Formungsoberfläche zu prägen; und
Zurückziehen (D) des Formkörpers von der formbaren Oberfläche;
**gekennzeichnet dadurch, daß** im Falle von von einem elektrischen Feld induziertem Druck der Formkörper und das Substrat Mehrschichtstukturen (10, 20) umfassen, die jeweils Schichten (14, 23) von aufladbaren oder leitfähigen Material distal zur Schnittstelle zwischen der Formungsoberfläche und der formbaren Oberfläche umfassen; und
im Falle von von einem magnetischen Feld induziertem Druck der Formkörper und das Substrat Mehrschichtstrukturen (10, 20) umfassen, die jeweils Schichten (14A, 23A) von magnetischem Material distal zur Schnittstelle zwischen der Formungsoberfläche und der formbaren Oberfläche umfassen; und
wobei mindestens eine der Mehrschichtstrukturen flexibel ist.

2. Verfahren nach Anspruch 1, wobei die formbare Oberfläche eine oder mehrere auf dem Substrat angeordnete formbare Schichten umfaßt.

3. Verfahren nach Anspruch 2, wobei das Prägen Bereiche verringerter Dicke in der formbaren Schicht erzeugt, wobei das Verfahren ferner die folgenden Schritte umfaßt:
Entfernen des Materials der formbaren Schicht von den Bereichen verringerter Dicke, um selektiv Bereiche des Substrats freizulegen; und
weiteres Verarbeiten des Substrats wahlweise in den freiliegenden Bereichen.

4. Verfahren nach Anspruch 3, wobei das weitere Verarbeiten das Dotieren des Substrats mit Unreinheiten, das Entfernen von Material vom Substrat oder das Hinzufügen von Material zum Substrat umfaßt.

5. Verfahren nach Anspruch 1, ferner umfassend das Härten (D) der formbaren Oberfläche nach dem Aufdrücken.

6. Verfahren nach Anspruch 1, wobei das Substrat oder der Formkörper oder beide ausreichend flexibel sind, um sich einander unter dem Druck anzupassen.

7. Verfahren nach Anspruch 2, wobei die Dicke der formbaren Schicht im Bereich 0,1 nm bis 200 µm liegt.

8. Vorrichtung zur Nano-Prägelitographie zum Prägen einer formbaren Oberfläche (22) auf einem Substrat (20) wobei die Vorrichtung umfaßt:
einen Formkörper (10) mit einer Formungsoberfläche (12), die mit hervorstehenden Merkmalen (13) von Nanoskalendimensionen gemustert ist;
ein Substrat (20) mit einer formbaren Oberfläche (22), die an die Formungsoberfläche des Formkörpers angrenzend angeordnet ist;
eine Einrichtung (14, 23) zum Bilden eines elektrischen Feldes zwischen dem Formkörper und dem Substrat, um die Formungsoberfläche und die formbare Oberfläche an einer Schnittstelle zwischen der formbaren Oberfläche und der Formungsoberfläche zusammenzudrücken;
**gekennzeichnet dadurch, daß** der Formkörper und das Substrat Mehrschichtstrukturen (10, 20) umfassen, die jeweils erste und zweite Schichten (14, 22) von aufladbarem oder leitfähigem Material distal zur Schnittstelle zwischen der Formungsoberfläche und der formbaren Oberfläche umfassen; und
wobei mindestens eine der Mehrschichtstrukturen flexibel ist.

9. Vorrichtung nach Anspruch 8, wobei mindestens eine der ersten und der zweiten Schicht leitfähig ist und die Einrichtung zum Bilden eines elektrischen Feldes eine Spannungsquelle (30) umfaßt.

10. Vorrichtung nach Anspruch 9, wobei die erste und die zweite Schicht leitfähiges Material umfassen.

11. Vorrichtung nach Anspruch 9, wobei die Spannungsquelle eine Gleichstromspannungsquelle umfaßt.

12. Vorrichtung nach Anspruch 9, wobei die Spannungsquelle eine Wechselstromspannungsquelle umfaßt.

13. Vorrichtung nach Anspruch 9, wobei die Spannungsquelle eine Pulsspannungsquelle umfaßt.

14. Vorrichtung nach Anspruch 9, wobei die Spannungsquelle eine Kombination von Gleichstrom, Wechselstrom und Pulsspannung bereitstellen kann.

15. Vorrichtung nach Anspruch 9, wobei der Formkörper eine leitfähige Schicht (14) enthält.

16. Vorrichtung nach Anspruch 10, wobei die Spannungsquelle zwischen den Schichten von leitfähigem Material verbunden ist.

17. Vorrichtung nach Anspruch 9, wobei der Formkörper und das Substrat zwischen mindestens zwei äußeren Elektroden (40, 41) angeordnet sind und die Einrichtung zum Bilden eines elektrischen Feldes eine Spannungsquelle zum Anlegen einer Spannung zwischen den außeren Elektroden umfaßt.

18. Vorrichtung nach Anspruch 17, wobei die spannungsquelle eine Wechselstrom- oder Pulsspannungsquelle ist.

19. Vorrichtung zur Nano-Prägelithographie zum Prägen einer formbaren Oberfläche auf einem Substrat (20), umfassend:
einen Formkörper (10) mit einer Formungsoberfläche (22), die mit hervorstehenden Merkmalen (13) von Nanoskalendimensionen gemustert ist;
ein Substrat (20) mit einer formbaren Oberfläche, die an die Formungsoberfläche angrenzend angeordnet ist; und
eine Magnetfeld-Erzeugungseinrichtung (50A, 50B), die dazu ausgelegt ist, ein magnetisches Feld zum Zusammendrücken der Formungsoberfläche und der formbaren Oberfläche an einer Schnittstelle zwischen der formbaren Oberfläche und der Formungsoberfläche zu erzeugen;
**gekennzeichnet dadurch, daß** der Formkörper und das Substrat Mehrschichtstrukturen (10, 20) umfassen, die jeweils Schichten (14A, 23A) von magnetischem Material distal zur Schnittstelle zwischen der Formungsoberfläche und der formbaren Oberfläche aufweisen; und
wobei mindestens eine der Mehrschichtstrukturen flexibel ist.

20. Vorrichtung nach Anspruch 19, wobei die magnetische Schicht eine leitfähige Spule oder Spirale umfaßt.

21. Vorrichtung nach Anspruch 19, wobei die Magnetfeld-Erzeugungseinrichtung eine leitfähige Spule oder Spirale umfaßt.

22. Vorrichtung nach Anspruch 19, wobei die magnetische Schicht eine Schicht von magnetisiertem Material umfaßt.

23. Vorrichtung nach Anspruch 19, wobei die magnetische Schicht eine Schicht von magnetisierbarem Material umfaßt.

## Revendications

1. Procédé de nano-empreinte lithographique pour le traitement d'une surface moulable (22) comprenant les étapes consistant à :
fournir (A) un substrat (70) comportant la surface moulable ;
fournir (A) un moule (10) comportant une surface de moulage (12) présentant un motif de caractéristiques saillantes ayant des dimensions à l'échelle nanométrique ;
presser (C) la surface de moulage et la surface moulable l'une contre l'autre par pression induite par champ magnétique ou électrique de façon à imprimer la surface de moulage sur la surface moulable au niveau d'une interface entre la surface de moulage et la surface moulable ; et
extraire (D) la surface moulable du moule ; **caractérise en ce que**, dans le cas d'une pression induite par champ électrique, le moule et le substrat comprennent des structures multicouches (10, 20) comprenant des coucher respectives (14, 23) de matériau chargeable ou conducteur distal par rapport à l'interface entre la surface de moulage et la surface moulable ; et
dans le cas d'une pression induite par champ magnétique, le moule et le substrat comprennent des structures multicouches (10, 20) comprenant des couches respectives (14A, 23A) de matériau magnétique distal par rapport à l'interface entre la surface de moulage et la surface moulable ; et
dans lequel au moins l'une des structures multicouches est flexible.

2. Procédé selon la revendication 1, dans lequel la surface moulable comprend une ou plusieurs couches moulables disposées sur le substrat.

3. Procédé selon la revendication 2, dans lequel l'impression produit des régions d'épaisseur réduite dans La couche moulable et comprend, en outre, les étapes consistant à :
enlever le matériau de la couche moulable des régions d'épaisseur réduite pour exposer sélectivement des régions du substrat ; et
traiter ultérieurement le substrat sélectivement dans les régions exposées.

4. Procédé selon la revendication 3, dans lequel le traitement ultérieur comprend le dopage du substrat avec des impuretés, l'enlèvement du matériau du substrat ou l'ajout, de matériau sur le substrat.

5. Procédé selon la revendication 1, comprenant, en outre, l'étape de durcissement (D) de la surface moulable après pression.

6. Procédé selon la revendication 1, dans lequel le substrat ou le moule, ou les deux, sont suffisamment flexibles pour s'épouser l'un l'autre sous la pression.

7. Procédé selon la revendication 2, dans lequel l'épaisseur de la couche moulable est comprise dans la plage de 0,1 nm à 200 µm.

8. Appareil de nano-empreinte lithographique pour l'impression d'une surface moulable (22) sur un substrat (20), l'appareil comprenant :
un moule (10) comportant une surface de moulage (12) présentant un motif de caractéristiques saillantes ayant des dimensions à l'échelle nanonétrique ;
un substrat (20) comportant une surface moulable (22) positionnée adjacente à la surface de moulage du moule ;
des moyens (14, 23) pour former un champ électrique entre le moule et le substrat afin de presser la surface de moulage et la surface moulable contre l'autre au niveau d'une interface entre la surface de moulage et la surface moulable ;
**caractérisé en ce que** le moule et le substrat comprennent des structures multicouches (10, 20) comprenant des première et seconde couches (14, 22) respectives de matériau chargeable ou conducteur distal par rapport à l'interface entre la surface de moulage et la surface moulable ; et
dans lequel au moins l'une des structures multicouches est flexible.

9. Appareil selon la revendication 8, dans lequel au moins l'une des première et seconde couches est conductrice et les moyens pour former un champ électrique comprennent une source de tension (30).

10. Appareil selon la revendication 9, dans lequel les première et seconde couches comprennent un matériau conducteur.

11. Appareil selon la revendication 9, dans lequel la source de tension comprend une source de tension continue.

12. Appareil selon la revendication 9, dans lequel la source de tension comprend une source de tension alternative.

13. Appareil selon la revendication 9, dans lequel la source de tension comprend une source de tension pulsée.

14. Appareil selon la revendication 9, dans lequel la source de tension peut comprendre une combinaison de tension continue, alternative et pulsée.

15. Appareil selon la revendication 9, dans lequel le moule comprend une couche conductrice (14).

16. Appareil selon la revendication 10, dans lequel la source de tension est reliée entre les couches de matériau conducteur.

17. Appareil selon la revendication 9, dans lequel le moule eL le substrat sont disposés entre au moins deux électrodes externes (40, 41) et les moyens pour former un champ électrique comprennent une source de tension pour appliquer une tension entre les électrodes externes.

18. Appareil selon la revendication 17, dans lequel la source de tension est une source de tension alternative ou une source de tension pulsée.

19. Appareil de nano-empreinte lithographique pour l'impression d'une surface moulable sur un substrat (20), comprenant :
un moule (10) comportant une surface de moulage (12) présentant un motif de caractéristiques saillantes (13) ayant des dimensions à l'échelle nanométrique ;
un substrat (20) comportant une surface moulable positionnée adjacente à la surface de moulage ;
et un générateur de champ magnétique (50A, 50B) apte à générer un champ magnétique pour presser la surface de moulage et la surface moulable l'une contre l'autre au niveau d'une interface entre la surface de moulage et la surface moulable ;
**caractérisé en ce que** le moule et le substrat comprennent des structures multicouches (10, 20) comprenant des couches (14A, 23A) respectives de matériau magnétique distal par rapport à l'interface entre la surface de moulage et la surface moulable ; et
dans lequel au moins l'une des structures multicouches est flexible.

20. Appareil selon la revendication 19, dans lequel la couche magnétique comprend une bobine ou une spirale conductrice.

21. Appareil selon la revendication 19, dans lequel le générateur de champ magnétique comprend une bobine ou une spirale conductrice.

22. Appareil selon la revendication 19, dans lequel le générateur de champ magnétique comprend une couche de matériau magnétisé.

23. Appareil selon la revendication 19, dans lequel la couche magnétique comprend une couche de matériau magnétisable.
